(19) Europäisches Patentamt
European Patent Office
Office européen des brevets

(11) **EP 3 201 638 B1**

(12) **FASCICULE DE BREVET EUROPEEN**

(45) Date de publication et mention
de la délivrance du brevet:
**01.08.2018 Bulletin 2018/31**

(21) Numéro de dépôt: **15766826.0**

(22) Date de dépôt: **21.09.2015**

(51) Int Cl.:
***G01R 31/11*** *(2006.01)*

(86) Numéro de dépôt international:
**PCT/EP2015/071606**

(87) Numéro de publication internationale:
**WO 2016/050547 (07.04.2016 Gazette 2016/14)**

(54) **PROCEDE D'ANALYSE D'UN CABLE, BASEE SUR UNE CORRELATION AUTO-ADAPTATIVE, POUR LA DETECTION DE DEFAUTS NON FRANCS**

VERFAHREN ZUR ANALYSE EINES KABELS, BASIEREND AUF EINER SELBSTANPASSENDEN KORRELATION, ZUM NACHWEIS VON NICHT EINDEUTIGEN DEFEKTEN

METHOD OF ANALYSING A CABLE, BASED ON AN AUTO-ADAPTIVE CORRELATION, FOR THE DETECTION OF NON-STRAIGHTFORWARD DEFECTS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **02.10.2014 FR 1459402**

(43) Date de publication de la demande:
**09.08.2017 Bulletin 2017/32**

(73) Titulaire: **COMMISSARIAT À L'ÉNERGIE ATOMIQUE ET AUX ÉNERGIES ALTERNATIVES
75015 Paris (FR)**

(72) Inventeurs:
• **SALLEM, Soumaya**
**F-60180 Nogent Sur Oise (FR)**
• **RAVOT, Nicolas**
**F-77500 Chelles (FR)**

(74) Mandataire: **Hammes, Pierre et al
Marks & Clerk France
Immeuble Visium
22, avenue Aristide Briand
94117 Arcueil Cedex (FR)**

(56) Documents cités:
**WO-A2-2005/109020   FR-A1- 2 907 910**

**Description**

L'invention concerne un procédé et un système de réflectométrie pour détecter et localiser des défauts non francs dans un câble. Le domaine de l'invention est celui des systèmes de diagnostic filaires basés sur le principe de la réflectométrie.

Les câbles sont omniprésents dans tous les systèmes électriques, pour l'alimentation ou la transmission d'information. Ces câbles sont soumis aux mêmes contraintes que les systèmes qu'ils relient et peuvent être sujets à des défaillances. Il est donc nécessaire de pouvoir analyser leur état et d'apporter des informations sur la détection de défauts, mais aussi leur localisation et leur type, afin d'aider à la maintenance. Les méthodes de réflectométrie usuelles permettent ce type de tests.

Les méthodes de réflectométrie utilisent un principe proche de celui du radar : un signal électrique, le signal de sonde, souvent de haute fréquence ou large bande, est injecté en un ou plusieurs endroits du câble à tester. Ledit signal se propage dans le câble ou le réseau et renvoie une partie de son énergie lorsqu'il rencontre une discontinuité électrique. Une discontinuité électrique peut résulter, par exemple, d'un branchement, de la fin du câble ou d'un défaut ou plus généralement d'une rupture des conditions de propagation du signal dans le câble. Elle résulte le plus souvent d'un défaut qui modifie localement l'impédance caractéristique du câble en provoquant une discontinuité dans ses paramètres linéiques.

L'analyse des signaux renvoyés au point d'injection permet d'en déduire des informations sur la présence et la localisation de ces discontinuités, donc des défauts éventuels. Une analyse dans le domaine temporel ou fréquentiel est habituellement réalisée. Ces méthodes sont désignées par les acronymes TDR venant de l'expression anglo-saxonne « Time Domain Reflectometry » et FDR venant de l'expression anglo-saxonne « Frequency Domain Reflectometry ».

L'invention s'applique à tout type de câble électrique, en particulier des câbles de transmission d'énergie ou des câbles de communication, dans des installations fixes ou mobiles. Les câbles concernés peuvent être coaxiaux, bifilaires, en lignes parallèles, en paires torsadées ou autre pourvu qu'il soit possible d'y injecter un signal de réflectométrie et de mesurer sa réflexion.

Les méthodes de réflectométrie temporelle connues sont particulièrement adaptées à la détection de défauts francs dans un câble, tel un court circuit ou un circuit ouvert ou plus généralement une modification locale significative de l'impédance du câble. La détection du défaut se fait par la mesure de l'amplitude du signal réfléchi sur ce défaut qui est d'autant plus importante et donc détectable, que le défaut est franc.

A l'inverse, un défaut non franc, par exemple résultant d'une dégradation superficielle de la gaine du câble de l'isolant ou du conducteur, engendre un pic d'amplitude faible sur le signal de réflectométrie réfléchi et est par conséquent plus difficilement détectable par des méthodes temporelles classiques.

La détection et la localisation d'un défaut non franc sur un câble est un problème important pour le monde industriel car un défaut apparait en général d'abord comme un défaut superficiel mais peut, avec le temps, évoluer vers un défaut plus impactant. Pour cette raison notamment, il est utile de pouvoir détecter l'apparition d'un défaut dès son apparition et à un stade où son impact est superficiel afin d'anticiper son évolution en un défaut plus important.

Les méthodes connues permettant l'identification de défauts non francs sur un câble sont le plus souvent des méthodes de réflectométrie temps-fréquence. Ces méthodes ont été développées afin de permettre une meilleure mise en évidence des signaux réfléchis de faible amplitude.

On connait notamment la méthode « Joint Time-Frequency Domain Reflectometry » décrite dans le document [1] qui propose l'utilisation de la transformée fréquentielle de Wigner-Ville. Cette méthode permet une meilleure discrimination des réflexions de signal sur des défauts non francs avec une bonne résolution temporelle et fréquentielle. Cependant, elle présente le double inconvénient d'être complexe à implémenter dans un système embarqué et induit des problèmes de fausse détection dus à l'existence de termes croisés dans la transformée précitée.

La demande de brevet français du Demandeur publiée sous le numéro FR 2981752 propose un perfectionnement de la méthode temps-fréquence décrite dans [1] qui permet d'éliminer l'influence des termes croisés et de supprimer les problèmes de fausse détection.

Cependant cette méthode présente toujours l'inconvénient d'une complexité importante de mise en oeuvre pour des équipements portatifs.

On connait par ailleurs également la demande de brevet français du Demandeur publiée sous le numéro FR 2907910 qui propose une autre méthode d'analyse basée sur l'injection, dans le câble à tester, de séquences pseudo-aléatoires.

L'invention propose une méthode d'analyse d'un câble en vue de la détection de défauts non francs qui présente une faible complexité d'implémentation et qui est particulièrement adaptée à une implémentation dans un dispositif embarqué portatif.

La méthode selon l'invention permet de détecter des signaux de très faible amplitude malgré un environnement de mesure bruité et la présence d'autres réflexions d'amplitudes plus importantes.

L'objectif visé par l'invention est atteint grâce à l'utilisation d'une fonction d'intercorrélation normalisée par un coefficient particulier permettant l'auto-adaptation du réflectogramme obtenu afin de faire ressortir les réflexions de faible amplitude.

L'invention a ainsi pour objet un procédé d'analyse d'un câble dans lequel un signal de référence s de support temporel limité à une durée T est injecté, comprenant le calcul de l'inter-corrélation, sur une fenêtre glissante de durée D au moins égale à 2T, entre ledit signal de référence s injecté et une mesure r de la réflexion dudit signal de référence s dans le câble, ledit procédé étant caractérisé en ce qu'il comporte en outre la normalisation de l'inter-corrélation calculée par un facteur dépendant de l'intégration de ladite mesure r de réflexion sur la même fenêtre glissante de durée D.

Selon un aspect particulier de l'invention, le facteur dépendant de l'intégration de la mesure r de réflexion est égal à la valeur absolue de ladite intégration élevée à une puissance inférieure à un.

Selon un aspect particulier de l'invention, ladite puissance est égale à ½.

Selon un aspect particulier de l'invention, le facteur dépendant de l'intégration de la mesure r de réflexion est égal au logarithme de la valeur absolue de ladite intégration.

Selon une variante de réalisation, le procédé d'analyse d'un câble selon l'invention comprend en outre les étapes suivantes :

- Le calcul de l'inter-corrélation, sur une fenêtre glissante de durée D au moins égale à 2T, entre ledit signal de référence s injecté et l'inter-corrélation normalisée calculée,
- La normalisation de l'inter-corrélation calculée à l'étape précédente par un facteur dépendant de l'intégration de l'inter-corrélation normalisée sur la même fenêtre glissante de durée D.

Selon une variante de réalisation, ledit procédé comporte en outre une étape de recherche d'au moins un extremum de l'inter-corrélation normalisée indiquant la présence d'un défaut sur le câble.

Selon un aspect particulier de l'invention, le signal de référence injecté est une impulsion Gaussienne.

L'invention a également pour objet un dispositif pour l'analyse d'un câble comprenant des moyens adaptés pour mettre en oeuvre le procédé d'analyse selon l'invention.

Ce dispositif peut comprendre des moyens de mesure, en un point du câble, d'un signal réfléchi dans le câble et un processeur configuré pour exécuter le procédé d'analyse selon l'invention.

L'invention a encore pour objet un système de réflectométrie comprenant un dispositif pour l'analyse d'un câble selon l'invention, ledit système pouvant comprendre en outre des moyens d'injection, en un point du câble, d'un signal de référence.

L'invention a encore pour objet un programme d'ordinateur comportant des instructions pour l'exécution du procédé d'analyse d'un câble selon l'invention, lorsque le programme est exécuté par un processeur et un support d'enregistrement lisible par un processeur sur lequel est enregistré un programme comportant des instructions pour l'exécution du procédé d'analyse d'un câble selon l'invention, lorsque le programme est exécuté par un processeur.

D'autres caractéristiques et avantages de la présente invention apparaîtront mieux à la lecture de la description qui suit en relation aux dessins annexés qui représentent :

- La figure 1, un organigramme illustrant les étapes du procédé d'analyse selon l'invention,
- La figure 2, un schéma d'un exemple de réalisation d'un dispositif d'analyse selon l'invention,
- La figure 3, un premier exemple de comparaison entre un réflectogramme temporel obtenu avec et sans application de l'invention,
- La figure 4, un second exemple de réflectogrammes illustrant les résultats obtenus en appliquant le procédé deux fois consécutivement,
- La figure 5, un troisième exemple de réflectogrammes illustrant les résultats en présence de bruit de mesure,
- La figure 6, un diagramme du gain d'amplitude obtenu pour un défaut non franc en appliquant l'invention en fonction du rapport signal à bruit,
- La figure 7, un diagramme du gain d'amplitude obtenu pour un défaut non franc en appliquant l'invention en fonction de la largeur d'impulsion

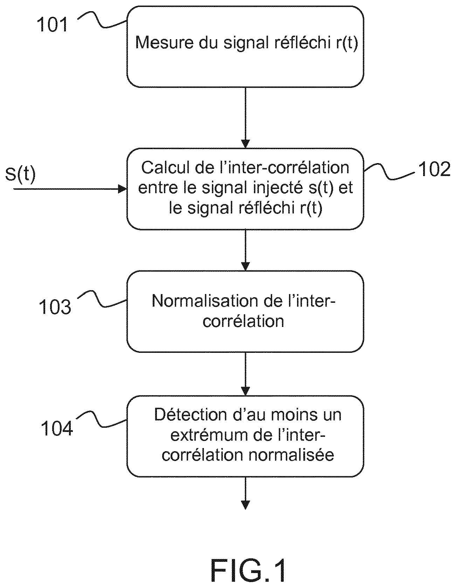

La figure 1 décrit les étapes principales de mise en oeuvre du procédé d'analyse selon l'invention.

Selon le principe bien connu des méthodes de réflectométrie, un signal de référence S(t) est injecté en un point du câble à analyser, ce point pouvant être une extrémité du câble ou un point d'injection disposé à un endroit quelconque du câble.

Selon une première étape 101 du procédé selon l'invention, une mesure de la réflexion r(t) du signal injecté est effectuée. Cette mesure peut être réalisée au point d'injection ou en un autre point de mesure disposé à un endroit quelconque du câble. La mesure du signal réfléchi est réalisée sur une durée donnée paramétrée notamment en fonction de la longueur du câble et de ses caractéristiques physiques (par exemple la vitesse de propagation du signal dans le câble).

Selon une deuxième étape 102, un calcul de l'inter-corrélation entre le signal injecté et le signal réfléchi est réalisé. L'inter-corrélation est avantageusement calculée sur une durée au moins égale à 2T où T est la durée du support temporel injecté. Par exemple si le signal injecté est une impulsion Gaussienne, T est la durée de l'impulsion.

$$c_1(t) = \int_{t-T}^{t+T} r(t')s(t' - t)dt'$$

Selon une troisième étape 103, un calcul de l'intégrale du signal réfléchi sur une durée au moins égale à 2T est effectué.

$$c_2(t) = \int_{t-T}^{t+T} r(t')dt'$$

Le terme $C_2(t)$ correspond à un facteur prêt à la moyenne du signal réfléchi r(t) sur une durée 2T ou encore à son énergie.

On calcule ensuite un facteur de normalisation à partir du terme $C_2(t)$. Ce facteur peut être par exemple égal à la racine carrée de la valeur absolue du terme $C_2(t)$ mais il peut, de façon plus générale être égal à une puissance inférieure à 1 de la valeur absolue du terme $C_2(t)$ ou encore au logarithme de ce terme. Sans sortir du cadre de l'invention, tout facteur de normalisation dépendant du terme $C_2(t)$ est envisageable.

On obtient à l'issu de l'étape 103, un réflectogramme temporel $z(t) = \dfrac{c_1(t)}{f(c_2(t))}$ avec f() une fonction mathématique au premier ordre. Par exemple, si f est la fonction racine carrée de la valeur absolue, le réflectogramme temporel obtenu sera de la forme $z(t) = \dfrac{c_1(t)}{\sqrt{|c_2(t)|}}$. choix de la fonction f() dépend notamment du niveau de bruit impactant la mesure du signal réfléchi.

L'utilisation d'un facteur de normalisation dépendant de l'énergie du signal réfléchi permet d'amplifier les signatures corrélées avec le signal d'injection avec un gain plus élevé pour les signatures d'amplitude faible qui sont représentatives de défauts non francs.

En outre les artefacts dus au bruit de mesure ne sont pas amplifiés par la méthode car le bruit est décorrélé du signal injecté.

Les étapes 102 et 103 sont appliquées sur une fenêtre temporelle glissante de durée au moins égale à 2T de sorte à construire un réflectogramme z(t) de durée égale à la durée de la mesure du signal réfléchi r(t).

L'invention est applicable à tout type de signaux de référence, par exemple une impulsion Gaussienne mais aussi une séquence numérique en bande de base du type STDR de l'acronyme anglais signifiant « Sequence time domain reflectometry », un signal à étalement de spectre du type SSTDR de l'acronyme anglais « Spread Spectrum time domain reflectometry » ou plus généralement tout type de signal utilisé en réflectométrie temporelle. Avantageusement, le signal de référence utilisé possède de bonnes propriétés d'autocorrélation.

Selon une variante de réalisation de l'invention, afin d'améliorer l'amplification des pics associés aux défauts non francs, le procédé est appliqué une seconde fois en remplaçant la mesure du signal réfléchi r(t) par le réflectogramme z(t) obtenu par la normalisation auto-adaptative de l'inter-corrélation.

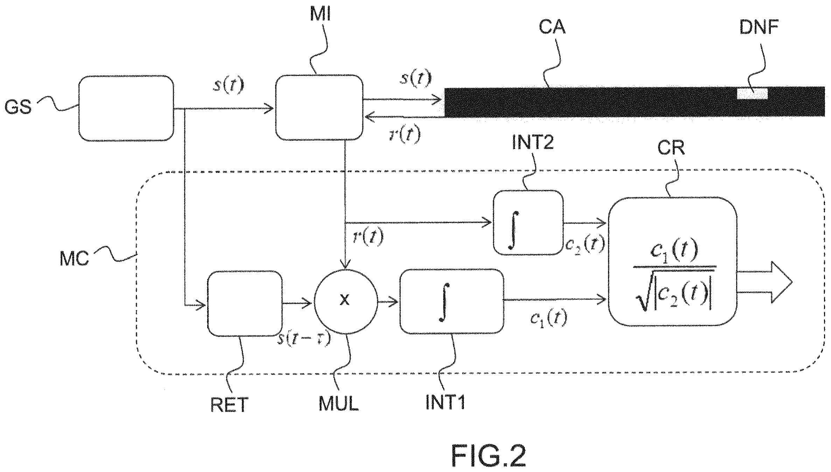

La figure 2 schématise, sur un synoptique, un exemple de système de réflectométrie apte à mettre en oeuvre le procédé selon l'invention.

Un système de réflectométrie, ou réflectomètre, comporte au moins un moyen GS, pour générer un signal de test et l'injecter dans le câble à analyser CA, un moyen de mesure MI pour mesurer le signal réfléchi dans le câble CA et un composant électronique MC de type circuit intégré, tel un circuit à logique programmable, par exemple de type FPGA ou un micro-contrôleur, par exemple un processeur de signal numérique, qui reçoit une copie du signal injecté s(t) et la mesure du signal réfléchi r(t) et est configuré pour exécuter le procédé d'analyse décrit à la figure 1 afin de générer un réflectogramme z(t).

Le moyen GS peut être constitué par un générateur de signal analogique, par exemple un signal sous la forme d'une impulsion Gaussienne ou tout autre signal de réflectométrie temporelle. Le moyen d'injection du signal dans le câble peut être constitué par un coupleur qui peut également servir à acquérir une mesure du signal réfléchi. Si le signal est généré numériquement, le moyen GS comprend également un convertisseur numérique analogique pour convertir le signal numérique en un signal analogique avant son injection dans le câble et un convertisseur analogique numérique pour réaliser l'opération inverse après l'acquisition de la mesure du signal réfléchi.

L'injection du signal dans le câble et la mesure du signal réfléchi peuvent être réalisées par un seul et même composant mais aussi par deux composants distincts, notamment lorsque le point d'injection et le point de mesure sont dissociés.

Le système décrit à la figure 2 peut être mis en oeuvre par une carte électronique sur laquelle sont disposés les différents composants. Le moyen de couplage et d'injection peut être connecté à une entrée/sortie que comporte la carte.

En outre, une unité de traitement, de type ordinateur, assistant numérique personnel ou autre peut être utilisée pour piloter le dispositif de réflectométrie et afficher les résultats des calculs effectués par le composant MC sur une interface homme-machine.

Le procédé selon l'invention peut être implémenté sur le composant MC à partir d'éléments matériels et/ou logiciels. Il peut notamment être mis en oeuvre en tant que programme d'ordinateur comportant des instructions pour son exécution. Le programme d'ordinateur peut être enregistré sur un support d'enregistrement lisible par un processeur.

Lorsque le composant MC est implémenté à partir d'éléments matériels, il comporte au moins une ligne à retard RET pour retarder le signal de test s(t), un multiplieur MUL pour multiplier le signal de test retardé avec la mesure du signal réfléchi r(t), un premier intégrateur INT1 pour intégrer le résultat de la multiplication sur une durée donnée afin de calculer l'inter-corrélation entre le signal injecté et le signal réfléchi. Le composant MC comporte d'autre part un second intégrateur INT2 pour intégrer la mesure du signal réfléchi r(t) sur la même durée que la durée d'intégration du premier intégrateur INT1. Le composant MC comporte enfin un module de calcul d'un réflectogramme CR à partir des sorties des deux intégrateurs INT1,INT2 et en appliquant le procédé selon l'invention. Les intégrateurs INT1, INT2 sont configurés pour réaliser des intégrations sur des fenêtres temporelles glissantes afin de produire en sortie des signaux de durée sensiblement égale à celle de la mesure du signal réfléchi r(t).

Le module de calcul CR peut être en outre configuré pour analyser le réflectogramme produit et en déduire une détection et/ou une localisation des défauts non francs. Cette analyse peut également être réalisée par une unité de traitement distincte du système selon l'invention qui reçoit une copie du réflectogramme généré et applique ensuite des traitements supplémentaires pour identifier les défauts non francs.

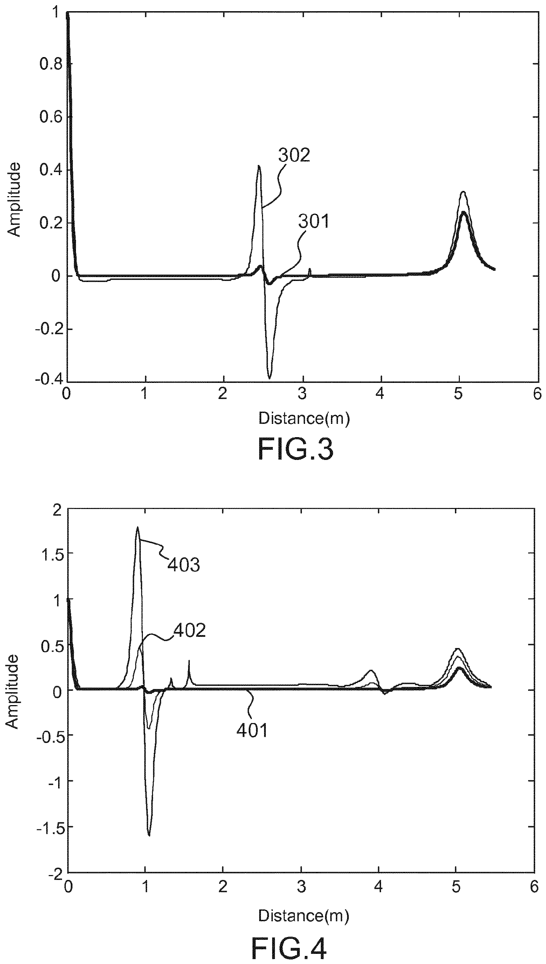

La figure 3 illustre un diagramme représentant l'amplitude d'un réflectogramme en fonction de la distance entre le point d'injection (identifié par l'abscisse 0) et les discontinuités d'impédance rencontrées par le signal lors de sa propagation dans le câble.

Sur la figure 3 est représenté un premier réflectogramme 301 qui correspond à une application classique d'une méthode de réflectométrie temporelle, autrement dit le premier réflectogramme 301 correspond à l'inter-corrélation $C_1(t)$ non normalisée. Un pic d'amplitude faible (aux alentours de l'abscisse 2,5) sur ce premier réflectogramme correspond à la présence d'un défaut non franc.

Un second réflectogramme 302 est représenté et correspond au réflectogramme z(t) obtenu par application de l'invention. On remarque que l'utilisation d'une corrélation normalisée permet d'amplifier fortement l'amplitude du défaut non franc afin de pouvoir mieux le discriminer.

La figure 4 représente un premier réflectogramme 401 correspondant à l'utilisation d'une inter-corrélation non normalisée, un deuxième réflectogramme 402 correspondant à l'application du procédé selon l'invention et un troisième réflectogramme 403 qui correspond à une deuxième application successive du procédé selon l'invention sur le réflectogramme obtenu à la première application du procédé.

On remarque que le double traitement appliqué au troisième réflectogramme 403 permet encore d'amplifier l'impulsion associée à un défaut non franc.

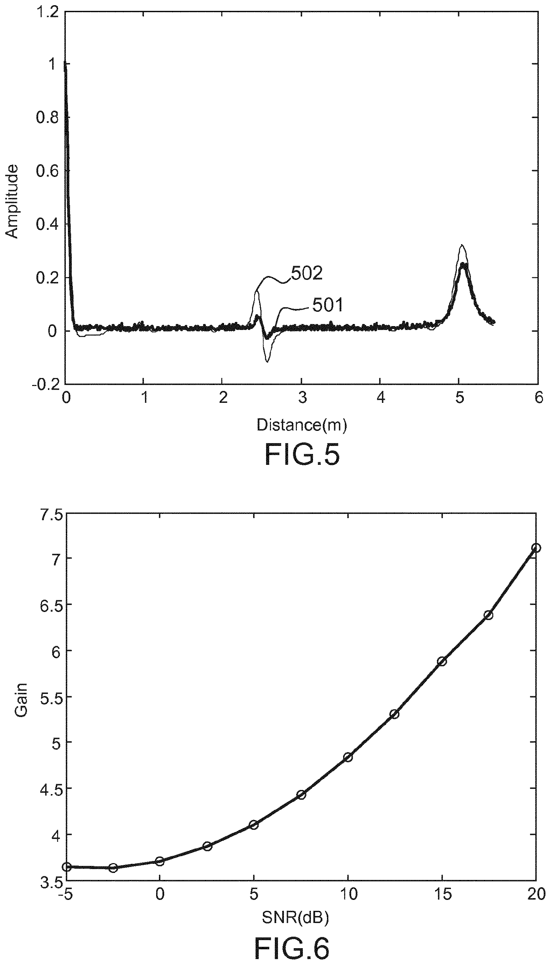

La figure 5 représente un premier réflectogramme 501 obtenu sans appliquer l'invention mais en présence de bruit de mesure. On peut remarquer que l'amplitude du pic associé à un défaut non franc est d'autant plus difficile à identifier que le niveau de bruit est important.

Le second réflectogramme 502 illustre le résultat obtenu en utilisant l'invention et montre que l'amplitude du pic correspondant au défaut non franc est amplifiée alors que les artefacts liés au bruit de mesure restent à un niveau similaire à celui du premier réflectogramme 501.

La figure 6 représente le gain d'amplification obtenu pour un pic associé à un défaut non franc en fonction du rapport signal à bruit représenté en abscisse en décibels. On remarque que même à faible rapport signal à bruit, un gain d'amplification est obtenu.

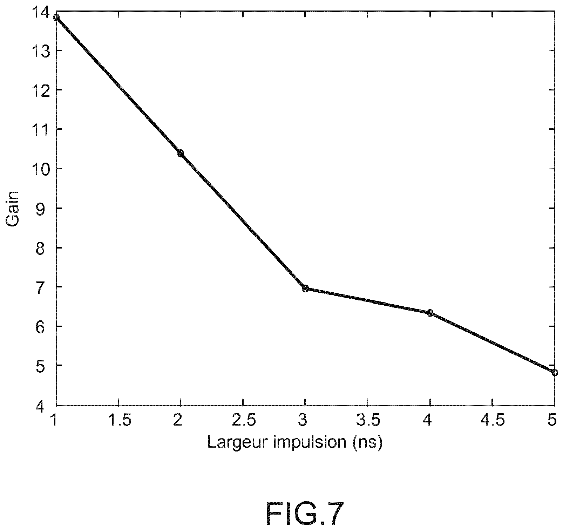

La figure 7 représente le gain d'amplification obtenu pour un pic associé à un défaut non franc en fonction de la largeur de l'impulsion du signal injecté, exprimé en abscisse en nanosecondes. On remarque que le gain d'amplification diminue lorsque la largeur d'impulsion augmente. Cette observation permet de paramétrer l'impulsion de signal injecté en fonction du niveau de discrimination que l'on souhaite obtenir pour la détection de défauts non francs.

L'invention s'applique à la détection de défauts non francs qui engendrent de très faibles variations d'impédance caractéristique. En particulier, de tels défauts incluent une éraflure ou une usure de la gaine, du diélectrique mais aussi le début de dégradation du conducteur métallique ou la compression d'un câble. Ces dégradations peuvent, au premier abord, sembler bénignes et sans répercussions notables pour le système. Cependant, si rien n'est fait, les contraintes mécaniques, environnementales ou encore le vieillissement du câble feront évoluer un défaut non franc vers un défaut franc, dont les conséquences, tant économiques que matérielles, peuvent être considérables. Détecter les défauts naissants permet une meilleure gestion de la maintenance et donc une réduction des coûts de réparation.

**Références**

[1] Y.J. Shin. « Theory and Application of Time-Frequency analysis to transient phenomena », in Electric Power and other Physical Systems. PhD Thesis, University of Texas, 2004.

**Revendications**

**1.** Procédé d'analyse d'un câble dans lequel un signal de référence s de support temporel limité à une durée T est injecté, comprenant le calcul (102) de l'inter-corrélation, sur une fenêtre glissante de durée D au moins égale à 2T, entre ledit signal de référence s injecté et une mesure r de la réflexion dudit signal de référence s dans le câble, ledit procédé étant **caractérisé en ce qu'**il comporte en outre la normalisation (103) de l'inter-corrélation calculée par un facteur dépendant de l'intégration de ladite mesure r de réflexion sur la même fenêtre glissante de durée D.

**2.** Procédé d'analyse d'un câble selon la revendication 1 dans lequel le facteur dépendant de l'intégration de la mesure r de réflexion est égal à la valeur absolue de ladite intégration élevée à une puissance inférieure à un.

**3.** Procédé d'analyse d'un câble selon la revendication 2 dans lequel ladite puissance est égale à ½.

**4.** Procédé d'analyse d'un câble selon la revendication 1 dans lequel le facteur dépendant de l'intégration de la mesure r de réflexion est égal au logarithme de la valeur absolue de ladite intégration.

**5.** Procédé d'analyse d'un câble selon l'une des revendications précédentes comprenant en outre les étapes suivantes :

- Le calcul de l'inter-corrélation, sur une fenêtre glissante de durée D au moins égale à 2T, entre ledit signal de référence s injecté et l'inter-corrélation normalisée calculée,
- La normalisation de l'inter-corrélation calculée à l'étape précédente par un facteur dépendant de l'intégration de l'inter-corrélation normalisée sur la même fenêtre glissante de durée D.

**6.** Procédé d'analyse d'un câble selon l'une des revendications précédentes dans lequel ledit procédé comporte en outre une étape (104) de recherche d'au moins un extremum de l'inter-corrélation normalisée indiquant la présence d'un défaut sur le câble.

**7.** Procédé d'analyse d'un câble selon l'une des revendications précédentes dans lequel le signal de référence injecté est une impulsion Gaussienne.

**8.** Dispositif pour l'analyse d'un câble (CA) comprenant des moyens (MC) adaptés pour mettre en oeuvre le procédé d'analyse selon l'une quelconque des revendications 1 à 7.

**9.** Dispositif pour l'analyse d'un câble selon la revendication 8 comprenant des moyens de mesure (MI), en un point du câble (CA), d'un signal réfléchi dans le câble et un processeur (MC) configuré pour exécuter le procédé d'analyse selon l'une quelconque des revendications 1 à 7.

**10.** Système de réflectométrie comprenant un dispositif pour l'analyse d'un câble selon l'une des revendications 8 ou 9.

**11.** Système de réflectométrie selon la revendication 10 comprenant en outre des moyens d'injection (MI), en un point du câble, d'un signal de référence.

**12.** Programme d'ordinateur comportant des instructions pour l'exécution du procédé d'analyse d'un câble selon l'une quelconque des revendications 1 à 7, lorsque le programme est exécuté par un processeur.

**13.** Support d'enregistrement lisible par un processeur sur lequel est enregistré un programme comportant des instructions pour l'exécution du procédé d'analyse d'un câble selon l'une quelconque des revendications 1 à 7, lorsque le programme est exécuté par un processeur.

**Patentansprüche**

**1.** Verfahren zum Analysieren eines Kabels, in das ein Referenzsignal s mit auf eine Dauer T begrenzter zeitlicher Unterstützung injiziert wird, das das Berechnen (102) der Interkorrelation, in einem Gleitfenster der Dauer D von wenigstens gleich 2T, zwischen dem injizierten Referenzsignal s und einem Maß r der Reflexion des Referenzsignals s in dem Kabel umfasst, wobei das Verfahren **dadurch gekennzeichnet ist, dass** es ferner die Normalisierung (103) der Interkorrelation beinhaltet, berechnet durch einen Faktor, der von der Integration des Reflexionsmaßes r im selben Gleitfenster von Dauer D abhängig ist.

**2.** Verfahren zum Analysieren eines Kabels nach Anspruch 1, in dem der von der Integration des Reflexionsmaßes r abhängige Faktor gleich dem Absolutwert der Integration erhöht auf eine Leistung von kleiner als eins ist.

**3.** Verfahren zum Analysieren eines Kabels nach Anspruch 2, in dem die Leistung gleich 1/2 ist.

**4.** Verfahren zum Analysieren eines Kabels nach Anspruch 1, bei dem der von der Integration des Reflexionsmaßes r abhängige Faktor gleich dem Logarithmus des Absolutwertes der Integration ist.

**5.** Verfahren zum Analysieren eines Kabels nach einem der vorherigen Ansprüche, das ferner die folgenden Schritte beinhaltet:

- Berechnen der Integration, in einem Gleitfenster der Dauer D von wenigstens gleich 2T, zwischen dem injizierten Referenzsignal s und der berechneten normalisierten Interkorrelation,
- Normalisieren der Interkorrelation, berechnet im vorherigen Schritt, durch einen von der Integration der im selben Gleitfenster der Dauer D normalisierten Interkorrelation abhängigen Faktor.

**6.** Verfahren zum Analysieren eines Kabels nach einem der vorherigen Ansprüche, bei dem das Verfahren ferner einen Schritt (104) des Suchens von wenigstens einem Extrem der normalisierten Interkorrelation beinhaltet, das die Anwesenheit eines Fehlers auf dem Kabel anzeigt.

**7.** Verfahren zum Analysieren eines Kabels nach einem der vorherigen Ansprüche, in dem das injizierte Referenzsignal ein Gaußscher Impuls ist.

**8.** Vorrichtung zum Analysieren eines Kabels (CA), die Mittel (MC) umfasst, ausgelegt zum Ausführen des Analyseverfahrens nach einem der Ansprüche 1 bis 7.

**9.** Vorrichtung zum Analysieren eines Kabels nach Anspruch 8, die Mittel (MI) zum Messen, an einem Punkt des Kabels (CA), eines in dem Kabel reflektierten Signals, und einen Prozessor (MC) umfasst, konfiguriert zum Ausführen des Analyseverfahrens nach einem der Ansprüche 1 bis 7.

**10.** Reflektometriesystem, das eine Vorrichtung zum Analysieren eines Kabels nach einem der Ansprüche 8 oder 9 umfasst.

**11.** Reflektometriesystem nach Anspruch 10, das ferner Mittel (MI) zum Injizieren, an einem Punkt des Kabels, eines Referenzsignals umfasst.

**12.** Computerprogramm, das Befehle zum Ausführen des Verfahrens zum Analysieren eines Kabels nach einem der Ansprüche 1 bis 7 umfasst, wenn das Programm von einem Prozessor ausgeführt wird.

**13.** Aufzeichnungsmedium, lesbar durch einen Prozessor, auf dem ein Programm aufgezeichnet ist, das Befehle zum Ausführen des Verfahrens zum Analysieren eines Kabels nach einem der Ansprüche 1 bis 7 umfasst, wenn das Programm von einem Prozessor ausgeführt wird.

**Claims**

**1.** A method for analysing a cable into which a reference signal s is injected with temporal support limited to a duration T, comprising computing (102) the inter-correlation, on a sliding window of duration D at least equal to 2T, between said injected reference signal s and a measurement r of the reflection of said reference signal s in the cable, said method being **characterised in that** it further comprises normalising (103) the computed inter-correlation by a factor depending on the integration of said reflection measurement r on the same sliding window of duration D.

**2.** The method for analysing a cable as claimed in claim 1, wherein the factor depending on the integration of the reflection measurement r is equal to the absolute value of said integration raised to a power lower than one.

**3.** The method for analysing a cable as claimed in claim 2, wherein said power is equal to ½.

**4.** The method for analysing a cable as claimed in claim 1, wherein the factor depending on the integration of the reflection measurement r is equal to the logarithm of the absolute value of said integration.

**5.** The method for analysing a cable as claimed in any one of the preceding claims, further comprising the following steps:

　　- computing the inter-correlation, on a sliding window of duration D at least equal to 2T, between said injected reference signal s and the computed normalised inter-correlation;
　　- normalising the inter-correlation computed during the preceding step by a factor depending on the integration of the normalised inter-correlation on the same sliding window of duration D.

**6.** The method for analysing a cable as claimed in any one of the preceding claims, wherein said method further comprises a step (104) of finding at least one extremum of the normalised inter-correlation indicating the presence of a fault on the cable.

**7.** The method for analysing a cable as claimed in any one of the preceding claims, wherein the injected reference signal is a Gaussian pulse.

**8.** A device for analysing a cable (CA) comprising means (MC) adapted for implementing the analysis method as claimed in any one of claims 1 to 7.

**9.** The device for analysing a cable as claimed in claim 8, comprising means (MI) for measuring, at a point of the cable (CA), a signal reflected in the cable and a processor (MC) configured to execute the analysis method as claimed in any one of claims 1 to 7.

**10.** A reflectometry system comprising a device for analysing a cable as claimed in any one of claims 8 or 9.

**11.** The reflectometry system as claimed in claim 10, further comprising means (MI) for injecting, at a point of the cable, a reference signal.

**12.** A computer program comprising instructions for executing the method for analysing a cable as claimed in any one of claims 1 to 7, when the program is executed by a processor.

**13.** A recording medium that can be read by a processor, on which recording medium a program is stored that comprises instructions for executing the method for analysing a cable as claimed in any one of claims 1 to 7, when the program is executed by a processor.

101 〜 Mesure du signal réfléchi r(t)

S(t) → Calcul de l'inter-corrélation entre le signal injecté s(t) et le signal réfléchi r(t) 〜 102

103 〜 Normalisation de l'inter-corrélation

104 〜 Détection d'au moins un extrémum de l'inter-corrélation normalisée

# FIG.1

FIG.2

FIG.3

FIG.4

FIG.5

FIG.6

FIG.7

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2981752

- FR 2907910

**Littérature non-brevet citée dans la description**

- Theory and Application of Time-Frequency analysis to transient phenomena. **Y.J. SHIN.** Electric Power and other Physical Systems. PhD Thesis. University of Texas, 2004